# FASCICULE DE BREVET EUROPEEN

(11) **EP 1 337 757 B1**
(45) Date de publication et mention de la délivrance du brevet: **24.05.2006**
(21) Numéro de dépôt: 01998156.2
(22) Date de dépôt: 30.11.2001
(51) Int. Cl.: F04B 53/10, B01J 19/00

(54) **VANNES ACTIVEES PAR DES POLYMERES ELECTRO-ACTIFS OU PAR DES MATERIAUX A MEMOIRE DE FORME, DISPOSITIF CONTENANT DE TELLES VANNES ET PROCEDE DE MISE EN OEUVRE**
DURCH ELEKTRISCH AKTIVE POLYMERE ODER DURCH MATERIALIEN MIT FORMGEDÄCHTNIS AKTIVIERTE VENTILE, EINRICHTUNG DAMIT UND VERFAHREN ZU IHRER VERWENDUNG
VALVES ACTIVATED BY ELECTRICALLY ACTIVE POLYMERS OR BY SHAPE-MEMORY MATERIALS, DEVICE CONTAINING SAME AND METHOD FOR USING SAME

(30) Priorité: 01.12.2000 FR 0015550
(43) Date de publication de la demande: 27.08.2003
(73) Titulaire: Biomerieux S.A., 69280 Marcy l'Etoile (FR)
(72) Inventeur: GARNIER, Francis, 94500 Champigny sur Marne (FR); MANDRAND, Bernard, 69100 Villeurbanne (FR); BROYER, Patrick, 01700 Beynost (FR); IMBAUD, Pierre, 69480 Pommiers (FR)
(74) Mandataire: Bonneau, Gérard
(86) Numéro de dépôt international: PCT/FR2001/003783
(87) Numéro de publication internationale: WO 2002/044566

(56) Documents cités:
- WO-A-97/22825
- WO-A-97/27324
- WO-A-97/33094
- FR-A- 2 795 476
- US-A- 6 033 191

## Description

La présente invention concerne le domaine de la micro-fluidique où des vannes sont utilisées pour diriger au moins un fluide mû par des moyens de transfert au sein d'une carte d'analyse.

Jusqu'à présent la plupart des cartes d'analyse comporte des évidements sur leurs deux faces planes et parallèles aux faces, ainsi que des évidements transversaux auxdites faces, l'ensemble de ces évidements constituant un réseau de canaux dans lequel un ou plusieurs fluides sont déplacés. Lesdits évidements sont délimités, au niveau des faces, par des films autocollants. Le contrôle des déplacements de fluides est assuré par des vannes.

Ce type de structure n'est pas réutilisable, puisque l'utilisation d'une vanne n'est efficace qu'une seule fois. Ainsi lorsque la vanne est basculée en position fermée, la surface autocollante du film vient également en contact avec le reste de la carte, et la vanne ne peut alors plus être utilisée. La vanne reste en position fermée.

La seule solution à ce problème consiste donc en le dépôt sur un film collant, d'une couche inerte, c'est-à-dire non collante, cette couche inerte étant réalisée préalablement par l'intermédiaire de découpes, par exemple dues à l'action d'emporte-pièces et positionnée précisément par rapport au film collant.

Ceci n'est pas aisé à réaliser techniquement, de plus le coût de fabrication d'un tel film complexe ainsi que les difficultés du bon positionnement de ce film sur la carte d'analyse, sont incompatibles avec une production en très grande quantité.

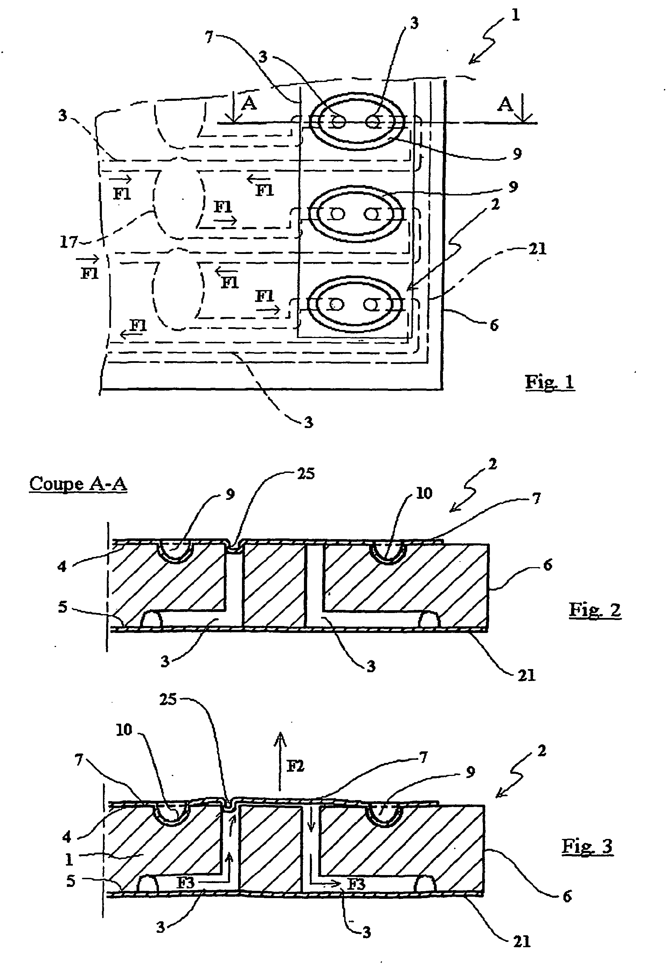

La demande de brevet WO-A-00/13795 déposée par la demanderesse propose une invention sur un dispositif ou carte d'analyse permettant de conduire une réaction ou au moins deux réactions en parallèle ou en série en son sein. Le dispositif est constitué par, d'une part, un réseau de canaux au sein duquel le transfert d'au moins un échantillon à traiter etlou à analyser est possible, et d'autre part, au moins une vanne incorporée au dispositif permettant l'orientation de chaque échantillon transféré au niveau du réseau et donc le contrôle des transferts, des réactions et des analyses dans ledit dispositif. Dans le mode de réalisation des figures 1 à 3, on remarque qu'une pastille en élastomère est insérée entre le film autocollant et le corps de la carte, ce qui autorise une réutilisation de la vanne.

Cette structure apporte donc bien une solution, néanmoins ceci augmente le nombre d'éléments et le coût pour permettre de réaliser une carte d'analyse fonctionnelle.

Le document WO-A-97/27324 essaie de trouver une solution à ce problème. Ainsi, il concerne une cassette pour conduire en parallèle des réactions qui comporte une ouverture d'entrée et une ouverture de sortie pour le transfert du ou des échantillons à introduire dans la cassette. Des vannes sont présentes au niveau de la cassette, qui ont une construction particulière (chambre de Bursapak, soupape à piston, valve à bille). Ces vannes permettent, sous l'action d'une force extérieure continue, de maintenir un canal fermé. Dans ce mode de réalisation, le film est soudé sur la cassette.

Toutefois, cette construction comporte un inconvénient majeur. Celui-ci consiste en la déformation de la face de la cassette subissant la soudure du film. Alors qu'à l'origine cette face est complètement plane la soudure entraîne une déformation préjudiciable à la bonne utilisation ultérieure de la cassette. Ceci peut aller de l'erreur de manipulation et/ou d'analyse à l'impossibilité de faire fonctionner les vannes. Le pire des problèmes peut être rencontré lorsque ce type de cassette est utilisé au sein d'un automate, ce qui est généralement le cas. Dans cette configuration, la carte déformée par la soudure peut bloquer l'ensemble de l'automate, voire le détériorer.

Un autre inconvénient de cette innovation réside dans l'absolu nécessité d'avoir une soudure précise du film sur la carte. Une erreur infime peut entraîner un bouchage de canaux et/ou une fuite de la vanne.

La demanderesse a également déposée une demande de brevet PCT/FR00/1719 sous priorité du 22 juin 1999, qui apporte une réponse concrète à l'ensemble des inconvénients de l'état de la technique ci-dessus développés. Ainsi, la soudure du film sur le corps de la carte d'analyse s'effectue sans détérioration de la face où la soudure est réalisée. De plus, la tolérance pour la position de la soudure est plus grande, puisque celle-ci ne fait que circonscrire la zone constituant la vanne et ne l'épouse pas au plus près. Cette invention concerne une vanne, traversée par au moins un canal,permettant de diriger au moins un fluide mû par des moyens de transfert au sein d'unecarte d'analyse, la carte comportant deux faces reliées l'une à l'autre par un bord,caractérisée par le fait qu'elle est constituée d'une part d'un film, flexible et/ou qui peut être déformé, fixé en partie sur au moins l'une des faces de ladite carte, et d'autre part d'un moyen de compression du film, moyen qui peut être activé ou désactivé. La fixation est réalisée au niveau d'au moins l'une des faces planes par l'intermédiaire d'une fixation située au niveau d'un renfoncement périphérique à la vanne, tel qu'une rainure. De plus, la fixation est assurée par une soudure périphérique à la vanne en fond de rainure.

Toutefois, les films flexibles qui sont utilisés dans l'état de la technique sont inertes, c'est-à-dire qu'ils n'ont que des propriétés de déformations structurelles suite à des contraintes physiques. La succession de ces contraintes ainsi que leur intensité, peut induire une déformation constante, pouvant entraîner soit la fermeture soit l'ouverture définitive. De plus, ces ouvertures et/ou fermetures par déformation obligent à disposer d'un mécanisme pour actionner le mouvement des films flexibles, ce qui est volumineux, lourd et onéreux.

Il existe des films qui ne sont pas inertes, il s'agit des polymères conducteurs intrinsèques, qui seront mieux définis par la suite de l'exposé. L'utilisation de tels films comme actionneurs est connus également comme le prouvent les demandes de brevet suivantes :
- WO-A-99/07997 à propos d'un moteur rotatif entraîné par un polymère conducteur,
- EP-A-0.735.518 qui propose une cellule de braille pourvue d'un actionneur qui contient un polymère à conductivité électrique intrinsèque, et
- WO-A-98/35529 présentant un actionneur sonique à film polymère diélectrique élastomère.

La demande de brevet WO-A-97/22825 propose un dispositif micro fluidique pour délivrer ou non un liquide ou un gaz présent dans une poche via un conduit (48). La fermeture ou l'ouverture du conduit, dont les cloisons sont souples, s'effectue par une valve comprenant un actionneur piézo-électrique qui peut fermer ou ouvrir le conduit par l'intermédiaire d'une lame métallique. La fermeture ou l'ouverture s'effectue en fonction du potentiel électrique appliqué au niveau de l'actionneur. De même, le brevet US-A-6,033,191 concerne plus particulièrement une pompe et non réellement une vanne. Cette pompe possède entre autre un actionneur piézo-électrique qui est superposé à la membrane de la pompe et même fixé par l'intermédiaire d'un agent de liaison conduisant l'électricité.

Contrairement à la présente invention, où l'actionneur est constitué par le seul courant électrique qui va déformer directement le film, l'actionneur selon l'état de la technique, constitué par les deux documents précédants, est en deux parties, qui subissent directement, pour le piézo-électrique, ou indirectement, pour la lame, le potentiel électrique, ces deux parties étant indépendante de la cloison qui elle se déforme toujours sous une action indirecte du courant électrique.

Conformément à la présente invention, il est prévu d'utiliser des polymères conducteurs très différents de ceux énumérés ci-dessus, et qui sont également appelés polymères électro-actifs. Ils permettent de réaliser des vannes et plus précisément des mini-vannes, qui sont normalement ouvertes ou fermées et qui deviennent respectivement fermées ou ouvertes lorsqu'un courant électrique leur est appliqué. Ce mécanisme simplifie considérablement leur conception et leur fonctionnement.

De tels polymères sont déjà connus mais leur utilisation est limitée pour le moment à la recherche fondamentale. L'utilisation de ces matériaux dans les vannes sur des cartes d'analyse de petite dimension est donc particulièrement intéressante et non évidente.

Par rapport à des vannes commandées mécaniquement ou pneumatiquement, les vannes commandées par des polymères électro-actifs ou des matériaux à mémoire de forme ont les avantages suivants :
- réduction de l'instrumentation associée à l'adressage des vannes,
- miniaturisation facilitée, une vanne peut avoir une taille de un micromètre (µm), et de là on peut obtenir une plus grande densité de vannes, ce qui permet de gérer des protocoles biologiques plus complexes, contenant plus d'étapes par exemple, et
- association de deux vannes au moins le long d'un même canal, qui, par un contrôle rigoureux de leur ouverture et fermeture, peut permettre de créer une micro-pompe.

Dans le cadre de la micro-pompe, il y a nécessité à synchroniser parfaitement l'ouverture et la fermeture des deux vannes concernées, ce qui est réalisable électriquement, mais beaucoup plus difficile mécaniquement, surtout avec des dimensions de l'ordre de quelques micromètres.

A cet effet, la présente invention concerne une vanne, traversée par au moins un canal, permettant de diriger au moins un fluide mû par des moyens de transfert au sein d'un dispositif, le dispositif comportant au moins une face, éventuellement plane, la vanne est constituée d'une part d'un film, flexible et/ou qui peut être déformé, fixé sur tout ou partie de la face dudit dispositif, et d'autre part d'un actionneur du film, qui permet d'activer ou de désactiver ladite vanne, cet actionneur étant constitué par une source électrique qui agit directement sur un polymère électro-actif ou sur un matériau à mémoire de forme.

Préférentiellement, le dispositif est constitué par une carte d'analyse comportant deux faces, éventuellement planes et reliées l'une à l'autre par un bord, la vanne est constituée d'une part d'un film, flexible et/ou qui peut être déformé, fixé sur tout ou partie d'au moins l'une des faces.

Selon une première variante de réalisation, le film est constitué par au moins une couche de polymère électro-actif permettant d'activer ou de désactiver directement la vanne.

Selon cette première variante, un premier mode de réalisation est représenté dans lequel le film est constitué d'une couche de polymère électro-actif associé à une membrane poreuse revêtue sur l'autre de ses faces d'une couche métallique d'or ou d'argent, le polymère électro-actif constituant soit l'électrode positive soit l'électrode négative et la couche métallique constituant l'électrode de polarité complémentaire de l'actionneur ou source de courant électrique.

Selon cette première variante, un second mode de réalisation est représenté dans lequel le film est constitué par une membrane poreuse revêtue sur chacune de ses faces d'une couche de polymère électro-actif, constituant pour l'une des couches l'électrode positive et pour l'autre couche l'électrode négative de l'actionneur ou source de courant électrique.

Dans ces deux modes de réalisation, une couche de polymère électro-actif est constituée de polyaniline et/ou de polypyrrole et/ou de polythiophène et/ou polyparaphénylvylène et/ou poly-(p-pyridyl vinylène), éventuellement associé à du polyéthylène.

Toujours dans ces deux modes de réalisation, la couche poreuse est constituée de tout matériau ou mélange de matériaux dont la porosité laisse passer les ions, tel que téflon, polyamide, cellulose, polyacétate et/ou polycarbonate.

Selon une deuxième variante de réalisation, un mécanisme de commande est présent entre le film et l'actionneur.

Selon cette deuxième variante, le mécanisme de commande est constitué en toute ou partie par un polymère électro-actif tel que défini précédemment, ou par un matériau à mémoire de forme, permettant d'activer ou de désactiver indirectement la vanne.

Dans le cas où un matériau en polymère électro-actif est utilisé, le polymère électro-actif est constitué par une bande longitudinale d'au moins une couche de polymère électro-actif. Dans le cas où un matériau à mémoire de forme est utilisé, il est constitué par un fil en alliage complexe dont la structure se modifie en fonction de la température, tel qu'un alliage de nickel et de titane.

De plus, selon la deuxième variante de réalisation, le matériau à mémoire de forme coopère avec un levier basculant et constituent ensemble toute ou partie du mécanisme de commande.

Plus précisément, le levier basculant est constitué d'une partie flexible et d'une partie rigide, la partie rigide coopérant avec un moyen de compression de la vanne, le matériau à mémoire de forme, le levier et le moyen de compression constituent ensemble toute ou partie du mécanisme de commande.

La présente invention concerne également une carte d'analyse contenant au moins une vanne, telle que décrite ci-dessus.

L'invention propose enfin un procédé d'activation d'une vanne, telle que décrite ci-dessus, qui consiste à :
- appliquer un courant électrique à un film ou un fil en polymère électro-actif ou en un métal à mémoire de forme en position de repos, la vanne étant en position ouverte ou fermée,
- maintenir le courant pour conserver le film ou le fil en position active correspondant à une action directe ou indirecte sur la vanne en position fermée ou ouverte, et
- arrêter le courant pour que ledit film ou fil retourne en position de repos et ladite vanne retourne en position ouverte ou fermée.

Les figures ci-jointes sont données à titre d'exemple explicatif et n'ont aucun caractère limitatif. Elles permettront de mieux comprendre l'invention.
La figure 1 représente une vue de dessus de la carte d'analyse, selon un premier mode de réalisation.
La figure 2 représente une vue en coupe selon A-A de la figure 1, lorsque la vanne est en position fermée.
La figure 3 représente une vue en coupe identique à la figure 2, lorsque la vanne est en position ouverte.
La figure 4 représente une vue semblable à la figure 3, c'est-à-dire lorsque la vanne est en position ouverte, d'un deuxième mode de réalisation.
La figure 5 représente une vue identique à la figure 4, mais lorsque la vanne est en position fermée.
La figure 6 représente une vue de dessus des figures 4 et 5.
La figure 7 représente une vue semblable aux figures 3 et 4, c'est-à-dire lorsque la vanne est en position ouverte, d'un troisième mode de réalisation.
La figure 8 représente une vue identique à la figure 7, mais lorsque la vanne est en position fermée.
La figure 9 représente une vue en perspective d'une carte d'analyse selon l'invention dans un quatrième mode de réalisation.
La figure 10 représente une vue en coupe selon B-B de la figure 9, lorsque la vanne est en position fermée.
La figure 11 représente une vue en coupe identique à la figure 10, lorsque la vanne est en position ouverte.
La figure 12 représente une vue de dessus d'un ensemble de cartes d'analyse, en vue partielle, selon les figures 10 et 11, dans laquelle toutes les vannes visibles sont en position fermée.
La figure 13 représente une vue identique à la figure 12, dans laquelle seule une des vannes visibles est en position ouverte.
La figure 14 représente une vue semblable à la figure 12, mais dans laquelle toutes les vannes visibles en position fermée sont fermées directement par le levier basculant.
Enfin, la figure 15 représente une vue identique à la figure 14, dans laquelle seule une des vannes visibles est en position ouverte.

### Carte d'analyse selon l'invention :

Une carte d'analyse 1 selon l'invention est une combinaison sur un même support de quelques centimètres carré (cm²) des fonctions de gestion des fluides (micro-fluidique), de réaction chimique et/ou biochimique, de séparation des espèces présentes dans le fluide et de détection de ces espèces. Ces systèmes peuvent permettre d'assurer de façon automatique et autonome toutes les fonctions de toute la chaîne d'analyse chimique et/ou biochimique classique en ne manipulant que de très faibles quantités de réactifs, comprises entre quelques microlitres et quelques nanolitres.

Les fonctions les plus couramment rencontrées pour ce type de carte d'analyse 1 sont représentées sur le tableau 1 ci-après. Cette liste n'est absolument pas exhaustive.

**Tableau 1 : Principales fonctions utilisées sur les cartes d'analyse selon l'invention**

| Gestion des fluides | Réaction | Séparation | Détection |
|---|---|---|---|
| Electrophorèse | | | Electrochimie Spectroscopie |
| Electro-osmose | Mélange | Electrophorèse | |
| Micropompage | Incubation | Electro-osmose | |
| Microvanne | Chauffage | Chromatographie | |
| Capteur | | | |

Les matériaux qui peuvent être utilisés pour réaliser ces cartes d'analyse 1 sont le silicium, les polymères, le quartz ou le verre. L'utilisation des polymères conducteurs et des polymères électro-actifs, définis plus loin, permet de réaliser de nombreuses autres fonctions.

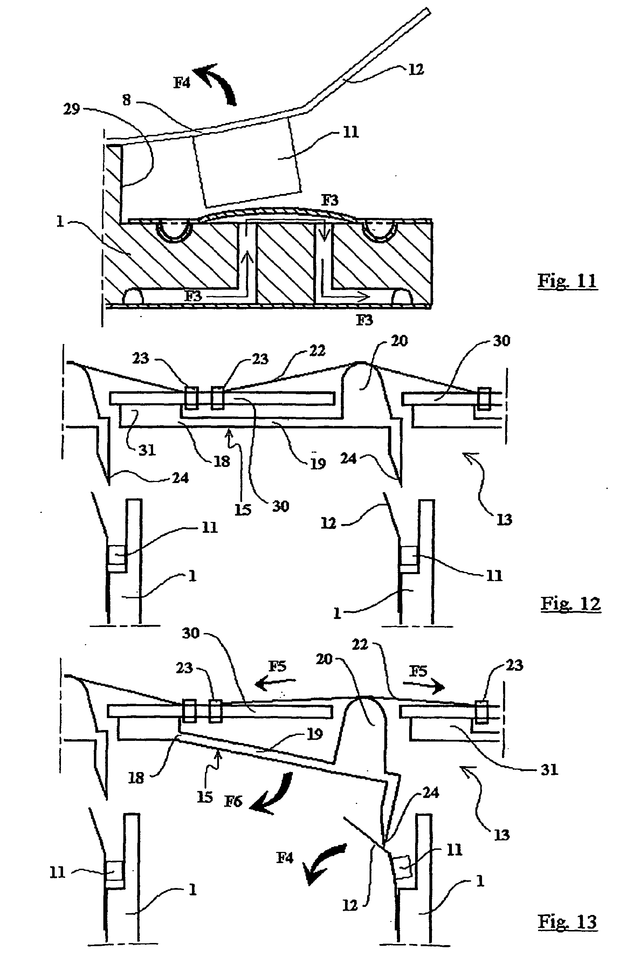

La présente invention concerne une carte réactionnelle 1 qui est constituée d'un parallélépipède rectangle comportant une face avant 4 et une face arrière 5 reliées l'une à l'autre, par un bord, également appelé tranche 6. Sur la figure 1 est donc représenté en traits pleins, l'ensemble des éléments qui constitue la face avant 4. On remarque entre autre, un certain nombre de canaux 3 qui sont débouchants au niveau de cette face 4. Ces canaux 3 sont cloisonnés par l'intermédiaire d'un film transparent 7, collé sur ladite face avant 4. Néanmoins, il n'est pas obligatoire que ce film 7, comme ceux qui seront décrits ci-dessous, soit transparent, il pourrait être opaque translucide, etc. La nature transparente permet néanmoins de mieux visualiser éventuellement la position d'une solution biologique à tester, ou tout autre solution introduite dans la carte 1. La face arrière 5 comporte également un film transparent référencé 21 qui cloisonne les canaux 3 représentés en pointillé car ils se trouvent, par endroit, affleurants au niveau de cette face arrière 5. Ce film 21 est très semblable à celui qui est représenté sur la face avant 4 des figures 10 et 11, qui constitue un autre mode de réalisation, et est référencé 16. Ces films 16 et 21 sont constitués de films BOPP (Biaxially Oriented PolyPropylen) ou autres films de même nature, qui sont soudés ou collés sur le corps de la carte 1, ce corps étant inerte par rapport aux solutions transférées et aux réactions qu'ils subissent. La nature du film 7 par contre est assez particulière puisqu'elle est en polymère électro-actif. Elle sera plus détaillée par la suite.

Chaque film 7, 16 ou 21 peut être présent sur toute la surface de la carte 1, c'est le cas pour les films 16 et 21, ou sur certaines portions de ladite carte 1, comme pour le film 7. Néanmoins, il peut ne pas y avoir de film 21, dans ce cas il est remplacé par une paroi réalisée dans la même matière que le reste du corps de la carte 1.

Le film 16 délimite la face extérieure des vannes 2 selon le mode de réalisation des figures 10 et 11. Celui-ci 16 est donc d'une nature suffisamment souple pour permettre le passage d'un liquide à tester, d'une solution traitée, d'un liquide de lavage, d'un liquide d'élution, etc. Il peut être constitué d'une membrane de silicone, de latex, en élastomère, par exemple Santopren (marque déposée), de films complexes sandwich à deux épaisseurs, tels que par exemple un couple en PE/PET (PolyEthylen / PolyEthylen Tetraphtalate) ou de films complexes sandwich à plus de deux épaisseurs, tels que par exemple un couple en SEBS/SBS (Styren Ethylen/Butylen Styrene / Styren Butylen Styrene).

De plus, le film transparent 16 situé au niveau de la face avant 4, et le film transparent 21 situé au niveau de la face arrière 5, peuvent être constitués d'un seul et même film transparent, ce qui facilite la fabrication de la carte 1 ainsi équipée.

Une carte d'analyse 1, selon l'invention, comporte en général plusieurs dizaines de vannes 2, comme cela est, par exemple, le cas dans les demandes de brevet PCT/FR00/01718, sous priorité du 22 juin 1999, et FR00/10978 du 28 août 2000, déposées par la demanderesse. Un exemple de mouvements des fluides (F1 de la figure 1) à l'intérieur du réseau de canaux 3 ou (F3 des figures 3, 4, 7 et 11) au niveau des vannes 2 sont d'ailleurs bien exposés dans la demande de brevet FR00/10978.

La commande de ces vannes 2 est le fait d'un adressage électrique qui sera précisé ultérieurement.

### Polymères conducteurs :

Pour information, les polymères conducteurs évoqués dans l'état de la technique ci-dessus, peuvent être de trois grands types :
- les polymères conducteurs extrinsèques, qui sont constitués d'une matrice polymèrique isolante à laquelle sont ajoutées des particules conductrices, généralement du noir de carbone, qui assurent la conduction électrique du matériau ; les polymères conducteurs extrinsèques ont de nombreuses applications industrielles dans le domaine de l'emballage (anti-statique ou anti-électromagnétique), de la protection électrique et de la connectique,
- les polymères conducteurs ioniques, qui peuvent être classés selon les polymères porteurs de groupes ioniques, les polymères gonflés de solution ionique et les électrolytes polymères solides ; la conductibilité du polymère est assuré par les ions présents dans le matériau ; les polymères conducteurs ioniques trouvent leur application industrielle dans les générateurs électrochimiques polymères,
- les polymères conducteurs intrinsèques, qui présentent une alternance de liaisons simple et double (polymère conjugué) ; cette structure électronique particulière est responsable de leurs propriétés conductrices, la conduction étant assurée par les chaînes hydrocarbonées du polymère ; certains ont des propriétés électriques (polyaniline, polypyrrole, polythiophène, polyacétylène) alors que d'autres ont des propriétés électroluminescentes (polyphénylène vinylène).

### Polymères électro-actifs :

Les polymères électro-actifs ont la propriété de se déformer lorsqu'ils sont soumis à une tension. Ils peuvent être scindés en deux familles répondant soit par un mouvement pendulaire soit par un mouvement longitudinal à une tension électrique, comme cela est bien représenté sur le tableau 2 suivant.

**Tableau 2 : Nature des polymères électro-actifs en fonction de leur mode de déplacement**

| **Mode de déplacement** | **Pendulaire** | **Longitudinal** |
|---|---|---|
| **Type de polymère** | Ionic Polymer Metal Composite (IPMC) | Electro-strictif |
| | | Piézo-électrique |
| | Bicouches/Multicouches Polypyrrole, polyaniline | Electrostatique |
| | | Gel polymère ionique |
| **Matériau** | Nanotubes de carbone, Alliage à mémoire de forme... | Céramique piézo-électrique... |

Il existe des produits sous forme de feuille appelé Nafion (marque déposée) d'une épaisseur de 180 µm et fabriqués par Dupont de Nemours aux Etats-Unis. Il s'agit d'un polymère perfluorosulfate, qui est recouvert ensuite avec des électrodes. Des informations complémentaires sur ce matériau peuvent être trouvées dans l'article de S. G. Wax et R. R. Sands, Electroactive Polymer Actuators and Devices. SPIE Vol. 3669, Mars 1999 ; 2-10, ou dans l'article de Y. Bar-Cohen, S. Leary, M.Shahinpoor, J. O. Harrison et J. Smith, Electro-Active Polymer (EAP) actuators for planetary applications. SPIE Vol. 3669, Mars 1999 ; 57-63 Les protons sont échangés contre des cations mobiles utilisés dans le processus d'échange, qui sont généralement le sodium (Na⁺) ou le lithium (Li⁺). Ceci nécessite la présence d'un solvant pour fonctionner et absorbe beaucoup d'eau. Les groupements SO₃⁻ sont fixés à la matrice de la membrane.

### Adressage électrique :

Concernant le problème de l'adressage électrique d'une matrice de nxn électrodes, correspondant à des vannes électro-actives, présentes sur une carte d'analyse, il est possible d'utiliser soit une technique de connexion directe soit un multiplexage.

La connexion directe est le schéma d'adressage le plus simple. Il consiste à relier chaque élément de la matrice X/Y par deux fils de connexion. Le support peut être indifféremment un support de silicium ou en polymère de taille variable grâce aux micro-technologies et aux techniques du circuit imprimé et de la sérigraphie.

La technique du multiplexage consiste à intégrer des fonctions électroniques sous les électrodes de la matrice (décodeur lignes - colonnes). Ces fonctions électroniques vont permettre, en fonction du choix de la ligne et de la colonne, d'adresser spécifiquement un point X/Y. Seules les techniques de la micro-électronique permettent de réaliser des composants intégrant des fonctions électroniques. Ce type de schéma d'adressage, qui fait appel aux technologies du circuit intégré, est réservé aux composants de faible taille réalisés sur silicium ou sur verre uniquement. De tels principes de multiplexage sont par exemple bien décrits dans le brevet US-A-5,965,452.

Le choix d'un schéma d'adressage dépend de la densité d'électrodes au cm² envisagée. Pour une densité d'électrodes supérieure à 100 par cm², une matrice multiplexée par les techniques de la micro-électronique sur silicium ou sur verre est généralement employée. Cette technique en raison de son faible coût au cm² doit être limitée à des composants de faible taille, de l'ordre de quelques mm², et convient à la réalisation de puces à ADN adressable électriquement. En revanche, pour des densités moins importantes, le schéma connexion directe peut être utilisé.

### Description de l'invention :

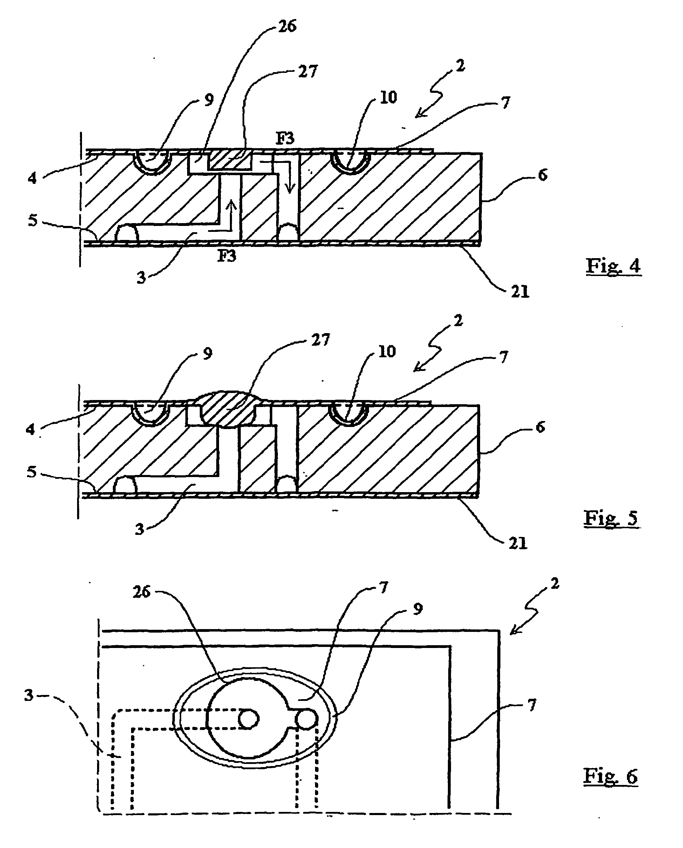

Les figures 1 à 8 représentent un premier mode de réalisation qui utilise un film 7 en polymère électro-actif, et qui permet l'action directe de la source de courant électrique sur ledit film 7. Ces figures décrivent en fait trois alternatives différentes de construction, représentées respectivement aux figures 1 à 3 pour la première variante de réalisation, aux figures 4 à 6 pour la deuxième variante de réalisation, et aux figures 7 et 8 pour la troisième variante de réalisation.

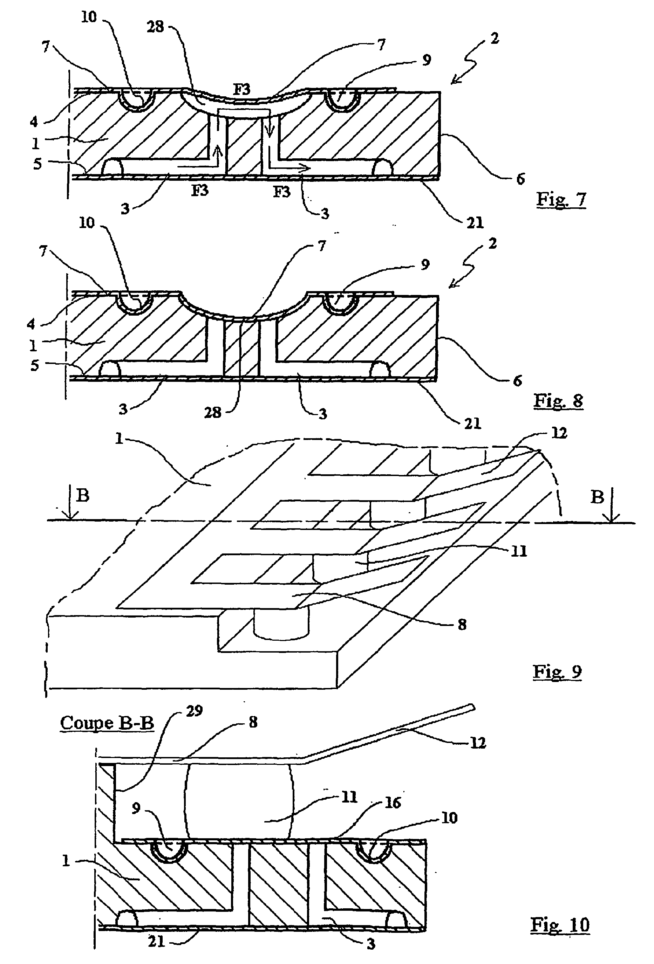

Les figures 9 à 13 représentent un second mode de réalisation qui utilise un film 16, normal, c'est-à-dire identique au film 21 situé au dos 5 de la carte 1, et qui permet l'action indirecte de la source de courant électrique sur ledit film 16, via un mécanisme de commande 13 intermédiaire. Ces figures décrivent une quatrième variante de réalisation.

Dans la suite de cette description, la référence aux variantes de réalisation sera effectuée en relation avec les explications données ci-dessus.

La présente invention concerne une carte d'analyse 1 qui est un support usiné de petite taille, par exemple de quelques centimètres carré et qui permet, à l'aide d'un réseau de circulation de fluides de gérer (par exemple électrophorèse, pompage, vannes, capteurs) des réactions (mélange, incubation, chauffage...) chimiques ou biochimiques et de séparer (électrophorèse, chromatographie, etc.) ou détecter (détection électrochimie, spectroscopique...) une ou plusieurs espèces présentes dans le fluide.

### 1°) Première variante de réalisation :

La figure 1 représente une première variante de réalisation qui reprend dans ces grandes lignes les caractéristiques des figures 4 à 6 décrites dans la demande de brevet PCT/FR00/01719 déposée par la demanderesse sous priorité du 22 juin 1999, à la différence que sur les figures de la présente invention, il n'y a aucune languette flexible. Dans ce cas, on remarque que chaque vanne 2 est constituée d'une petite surface plane située au même niveau que le reste de la surface plane de ladite carte 1 (voir également les figures 2 et 3). Cette petite surface plane comprend au moins un canal d'arrivée 3 et un canal de départ 3, le point d'intersection entre cette surface et les canaux 3 d'arrivée et de sortie du fluide étant au contact du film 7 comme cela est bien représenté sur la figure 2. Dans ce cas, la vanne est fermée. On remarque d'ailleurs sur la figure 2 que le film 7 comporte une invagination 25, qui a pour fonction de boucher un des deux canaux 3. Bien entendu, des invaginations 25 peuvent boucher également l'autre canal 3 ou les deux canaux 3 de chaque vanne 2. De plus, au niveau de la vanne 2, il peut y avoir plus de canaux 3, c'est-à-dire trois et au-delà.

On remarque également que la carte comporte un certain nombre de compartiments 17. Les compartiments 17 sont reliés aux vannes par l'intermédiaire des canaux 3 et il est possible mais cela n'est pas représenté sur la figure que d'autres vannes et d'autres compartiments soient présents sur le reste de la carte 1 ce qui permet d'effectuer des mélanges entre deux réseaux de canaux 3 situés en parallèle et non plus en série.

Sur les figures 2 et 3, on remarque la présence, sur la face supérieure 4 de la carte 1, au moins au niveau de la vanne 2, d'un film flexible 7 qui n'est pas autocollant comme ceci a été expliqué en analyse de l'état de la technique. Ce film 7 est donc soudé en 10 au niveau d'une rainure 9 périphérique à la vanne 2. Cette technique particulière est décrite ici à titre d'exemple représentatif d'un mode de réalisation sans caractère limitatif, il est d'ailleurs déjà bien décrit dans la demande PCT/FR00/01719. Néanmoins, sur la face inférieure 5 de ladite carte 1, il est possible d'utiliser un film autocollant 21 bien connu de l'état de la technique. Bien entendu, il est également possible d'avoir un deuxième film flexible 7 sur cette autre face en fonction des positions d'un seul côté ou de part et d'autre de la carte 1 de vannes 2. Les faces supérieure 4 et inférieure 5 sont reliées l'une à l'autre par un bord 6.

En fait, le fluide ou les fluides présents dans la carte d'analyse 1 sont mus selon F1 au sein de cette carte 1 par l'intermédiaire d'une mise sous pression ou une dépression qui est créée. Le mouvement du fluide au niveau d'une vanne 2, selon F3 de la figure 3, est autorisé en déformant l'invagination 25 selon F2, par application d'une tension électrique provoquant la mobilisation des ions dans le film polymère conducteurs. Cette mobilité des ions entraîne la déformation, la contraction ou la dilatation du film par le déplacement des molécules d'eau. La réponse tension-courant est typiquement voltamogramme qui comporte une hystérésis importante entre l'oxydation et la réduction. Un exemple de l'évolution du courant en fonction de la tension appliquée peut être trouvé par exemple dans l'article de T. W. Lewis, L. A. P. Kane-Maguire, A. S. Hutchinson, G. M. Spinks et G. G. Wallace, Development of an all-polymer, axial force electrochemical actuator. Synthetic Metals 102 (1999) 1317-1318.

Ainsi, le film 7 va pouvoir être déformé et le fluide pourra passer selon F3 comme cela est bien représenté. Il est donc nécessaire que le film 7 soit en un matériau qui se déforme sous l'action de ce courant électrique et qui revienne en position d'obturation selon la figure 2, dès que ledit courant n'est plus appliqué.

Selon un premier mode de construction, le polymère électro-actif formant le film 7 est constitué par une membrane poreuse revêtue sur l'une de ses faces d'une couche d'or ou d'argent, constituant à la fois les électrodes positive et négative de la source de courant électrique.

Selon un second mode de construction, le polymère électro-actif est constitué par une membrane poreuse revêtue sur chacune de ses faces d'une couche conductrice, constituant pour l'une des couches l'électrode positive et pour l'autre couche l'électrode négative de la source de courant électrique.

Cette couche conductrice est constituée de polyaniline et/ou de polypyrrole, qui répondent par un mouvement pendulaire à une excitation électrique.

### 2°) Deuxième variante de réalisation :

Cette variante reprend les mêmes constituants et donc les mêmes références que ceux de la première variante, à savoir la vanne 2, les canaux 3, les faces 4 et 5 de la carte d'analyse 1, le bord 6 de ladite carte 1, le film en polymère électro-actif 7 porté par la face 4 de la carte 1, le renfoncement ou rainure périphérique 9 à la vanne 2, la soudure périphérique 10 située au fond de la rainure 9 et le film 21.

Par contre, la face supérieure 4 de la carte 1 comporte un évidement 26, dont les dimensions (diamètre et profondeur supérieurs) permettent :
- la présence d'un épaississement 27 (diamètre et profondeur inférieurs) du film 7, et
- que les deux canaux 3 impliqués dans la vanne 2 soient débouchants au niveau de cet évidement 26.

Lorsque l'on applique une différence de potentiel telle que définie précédemment dans la première variante de réalisation, le film 7 va pouvoir gonfler et le fluide ne pourra alors plus passer selon F3 comme cela est bien représenté sur la figure 5. Il est donc nécessaire que le film 7 soit en un matériau qui se déforme sous l'action de ce courant électrique et qui revienne en position pour laisser le passage au fluide selon F3, voir la figure 4, dès que ledit courant n'est plus appliqué.

C'est donc l'effet inverse de la première variante de réalisation, lorsque l'on applique un courant électrique, la vanne 2 selon cette première variante de réalisation est ouverte, alors qu'elle 2 est fermée selon la deuxième première variante de réalisation, et vice versa.

Bien entendu, l'évidement 26 est de diamètre inférieur à la partie plane circonscrite par la rainure périphérique 9.

### 3°) Troisième variante de réalisation :

Cette troisième variante reprend les mêmes constituants et donc les mêmes références que ceux des première et deuxième variantes, à savoir la vanne 2, les canaux 3, les faces 4 et 5 de la carte d'analyse 1, le bord 6 de ladite carte 1, le film en polymère électro-actif 7 porté par la face 4 de la carte 1, le renfoncement ou rainure périphérique 9 à la vanne 2, la soudure périphérique 10 située au fond de la rainure 9 et le film 21.

Par contre, la face supérieure 4 de la carte 1 comporte une concavité 28, dont les dimensions sont suffisantes pour que les deux canaux 3 impliqués dans la vanne 2 soient débouchants au niveau de cette concavité 28.

Lorsque l'on applique une différence de potentiel telle que définie précédemment dans les première et deuxième variantes de réalisation, le film 7 va pouvoir être déformé et épousé la forme de la concavité 28, ce qui va empêcher le fluide de passer selon F3 comme cela est bien représenté sur la figure 8. Il est donc nécessaire que le film 7 soit en un matériau identique aux deux premières variantes de réalisation ci-dessus exposées.

Dès que l'action de ce courant électrique cesse, le film 7 revient dans sa position initiale, selon la figure 7 et laisse ainsi le passage au fluide selon F3.

Bien entendu il est possible d'envisager le phénomène inverse, c'est-à-dire que le polymère électro-actif 7 ferme la vanne 2 au repos, et ouvre ladite vanne 2 dès que le courant est appliqué.

### 4°) Quatrième variante de réalisation :

La figure 9 représente une carte 1 différente des précédentes même si elle conserve la même référence. Ainsi celle-ci se singularise par l'absence du film en polymère électro-actif 7 qui est remplacé par un film 16, bien représenté sur les figures 10 et 11, et dont les caractéristiques sont essentiellement mécaniques comme cela a été évoqué précédemment.

Cette quatrième variante concerne une carte réactionnelle 1 qui est constituée, à l'instar des précédentes, d'un parallélépipède rectangle comportant une face avant 4 et une face arrière 5 reliées l'une à l'autre, par un bord qui comporte un épaulement 29.

Sur les figures 10 et 11, une vanne 2 est représenté plus en détail. On note qu'au repos celle-ci 2 est en position fermée, puisque le film 16 est plaqué sur la face où débouchent les canaux 3 qui constituent ladite vanne 2. La position fermée est rendue possible par la présence d'un moyen de compression ou languette 8, fixé sur la face 4 de la carte 1 par une partie de sa surface, l'autre partie surplombant ladite vanne 2. Pour assurer un contact et une étanchéité parfaite de la vanne 2, un pion en élastomère 11 porté par la languette 8 assure la liaison au repos entre ladite languette 8 et le film 16.

On remarque la présence au niveau de l'extrémité libre de la languette 8 d'un biseau 12 qui facilite l'ouverture de ladite vanne 2. Le rôle de ce biseau 12 est de permettre le basculement de ladite languette 8, selon F4 de la figure 11, sous l'action d'un élément extérieur, qui sera décrit ultérieurement.

Le mode de fonctionnement de cette vanne 2 est donc différent des trois variantes précédentes, puisque le courant électrique n'a pas d'action directe sur le film 16. Si l'on se cantonne à observer la carte 1, seule la présence ou l'absence de la languette 8, par l'intermédiaire de son pion en élastomère 11, permet respectivement la fermeture ou l'ouverture de ladite vanne 2.

L'élément extérieur qui est mis en oeuvre pour permettre le déplacement selon F4 de la languette 8 est représenté sur les figures 12 et 13. Il s'agit d'un mécanisme de commande 13 porté par le châssis 30 d'un appareil automatique d'analyse, non représenté sur les figures. Ce châssis 30 porte au moins un levier 15 qui est constitué de plusieurs parties :
- une base 31 pour le solidariser audit châssis 30,
- une partie flexible 18, formant axe d'articulation de la partie suivante 19,
- une partie rigide 19 pour transmettre le mouvement de basculement selon F6,
- un bossage d'appui 20, dont la fonction sera exposée par la suite, et
- une extrémité 24, éventuellement biseautée, qui agit sur la languette 8 (mouvement selon F4) et plus précisément sur le biseau 12 de cette languette 8.

Ce basculement selon F6 est bien visible sur la figure 13. Il est le fait d'un fil en matériau à mémoire de forme 22, dont chacune des deux extrémités est en contact avec une borne de connexion électrique 23 permettant l'adressage. Ainsi chaque fil 22 est adressé et positionné électriquement via un simple transistor, non représenté sur les figures, directement commandé par l'électronique de l'instrument. De ce fait au niveau de chaque borne de connexion électrique 23 en série, permettant l'adressage, on applique une tension de l'ordre d'un à quelques volts, ce qui dilate le ou les fil(s) 22. Si les fils 22 sont en série, l'application d'une tension au niveau d'une borne 23 provoque la dilatation de tous les fils 22 positionnés en série. Si par contre chaque borne 23 sépare électriquement les deux fils électriques 22 qui en sont issus, l'adressage pourra être effectué en relation avec tout ou partie de ces fils.

Le long d'un fil 22, un autre contact existe avec le bossage d'appui 20 qui sert de moyen de transmission de la force de rétreint F5 dudit fil 22, pour assurer le basculement F6 de la partie rigide 19 du levier 15. De tels fils 22 peuvent être constitués par des fils en FLEXINOL (marque déposée) en alliage complexe de nickel - titane qui ont été achetés auprès de la société DYNALLOY Inc. (Costa Mesa, Californie, Etats-Unis d'Amérique). A température ambiante, ce fil 22 est étiré facilement, mais lorsqu'il est traversé par un courant suffisant, c'est-à-dire environ 1000 milliampères (mA) sous 0,3 Volt par centimètre (V/cm), sa longueur se réduit de 3 à 5 % en exerçant une traction d'environ 900 gramme.force (g.force). Néanmoins, cette force est fonction du diamètre du fil, comme cela est bien représenté dans le tableau 3 ci-dessous :

**Tableau 3 : Performance des fils à mémoire de forme en fonction de leur diamètre**

| **Diamètre du fil (mm)** | **Force de rétreint (g.force)** | **Force de relaxation (g.force)** | **Courant typique (mA) sous 0,3V/cm** |
|---|---|---|---|
| 0,05 | 35 | 8 | 50 |
| 0,10 | 150 | 28 | 180 |
| 0,15 | 330 | 62 | 400 |
| 0,25 | 930 | 172 | 1000 |
| 0,38 | 2000 | 380 | 2500 |

Les temps de réponse permettent de 13 à 65 cycles par minute, pour une température de transition de 90°C. Le nombre de cycles est de 9 à 40 si cette température est de 70°C. La durée de vie de ce type de fil 22 est d'au moins un million de cycles.

Comme représenté sur les figures 12 et 13, l'appareil automatique d'analyse peut contenir plusieurs carte 1 en parallèle, elles 1 pourraient néanmoins être montées également en série, ou les deux à la fois (série et parallèle). Dans un mode de réalisation de l'invention, la distance séparant deux cartes 1 en parallèle est de 25 mm. De même, il est possible d'avoir les uns au-dessus des autres de nombreux leviers 15, afin de permettre l'ouverture de plusieurs vannes 2 situées côte à côte sur une carte 1. Le pas existant entre deux leviers 15 adjacents et travaillant sur une même carte 1 est généralement compris entre 1 et 5 mm. Préférentiellement, ce pas a une valeur utilisée dans le domaine électronique, telles que 3,96 mm, 2,54 mm ou 1,28 mm.

### 5°) Cinquième variante de réalisation :

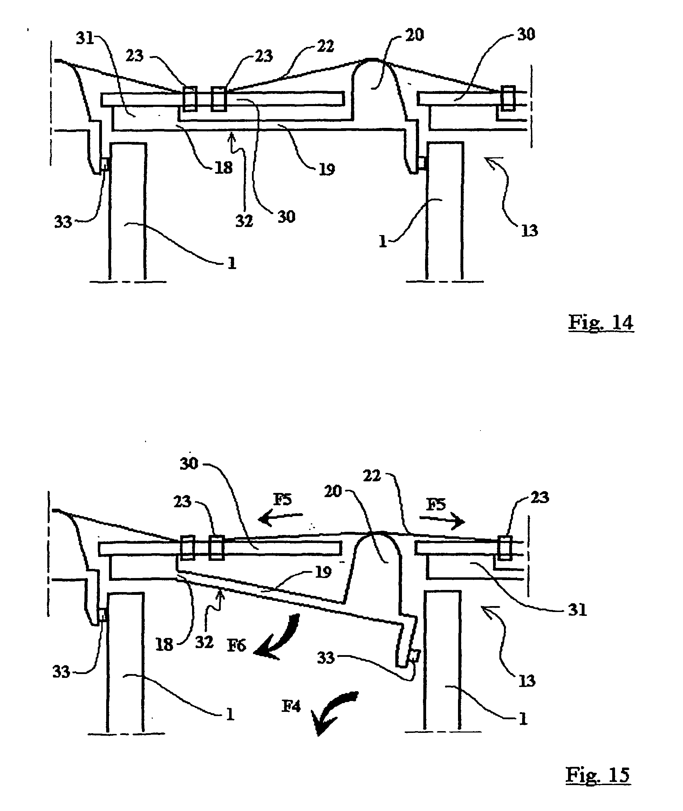

Les figures 14 et 15 représentent une carte 1 différente des précédentes même si elle conserve la même référence. Ainsi celle-ci 1 se singularise par l'absence du film en polymère électro-actif 7 qui est remplacé par un film 16, bien représenté sur les figures 10 et 11, et dont les caractéristiques sont essentiellement mécaniques comme cela a été évoqué précédemment. Cette cinquième variante est une évolution simplifiée de la quatrième variante.

La différence essentielle réside dans le fait que la carte 1 ne comporte pas de moyens de compression 8. La carte 1 possède donc des vannes normalement ouvertes au repos, alors qu'elles étaient normalement fermées pour la quatrième variante.

Le mécanisme de commande 13 est donc plus simple, selon cette cinquième variante, car le levier 32 agit directement sur ladite carte 1, ainsi l'extrémité libre de celui-ci 32, non référencée, est munie d'un moyen de fermeture étanche ou pion de compression en élastomère 33. Ce pion compresse le film 16 lorsque le fil en matériau à mémoire de forme 22, déjà décrit dans la variante précédente, n'est pas sous tension.

Il est également possible de prévoir que le fil 22 est remplacé par une bande longitudinale d'un matériau en polymère électro-actif, selon les trois premières variantes de réalisation.

### REFERENCES

1. Dispositif ou carte d'analyse
2. Vanne
3. Canal
4 et 5. Faces de la carte 1
6. Bord de la carte 1
7. Film en polymère électro-actif porté par la face 4 de la carte 1
8. Moyen de compression du film 7 ou languette flexible
9. Renfoncement ou rainure périphérique à la vanne 2
10. Soudure périphérique située au fond de la rainure 9
11. Moyen de fermeture étanche ou pion de compression en élastomère porté par le moyen ou languette 8
12. Moyen d'ouverture ou biseau porté par le moyen ou languette 8
13. Mécanisme de commande
14. Matériau à mémoire de forme constituant le mécanisme de commande 13
15. Levier basculant constituant le mécanisme de commande 13
16. Film flexible et/ou qui peut être déformé porté par la face 4 de la carte 1
17. Compartiment de la carte 1
18. Partie flexible du levier 15
19. Partie rigide du levier 15
20. Bossage d'appui du levier 15
21. Film porté par l'autre face 5 de la carte 1
22. Fil en matériau à mémoire de forme
23. Borne de connexion électrique permettant l'adressage
24. Extrémité biseautée du levier 15 agissant sur la languette 8
25. Invagination du film 7
26. Evidement portée par la face 4 de la carte 1
27. Epaississement 27 du film 7 au niveau de l'évidement 26
28. Concavité portée par la face 4 de la carte 1
29. Epaulement de la carte d'analyse 1
30. Châssis d'un appareil automatique d'analyse
31. Base 31 du levier 15 solidaire du châssis 30
32. Levier basculant constituant le mécanisme de commande 13
33. Moyen de fermeture étanche ou pion de compression en élastomère porté par le levier 32
F1. Mouvements fluidiques au niveau de la carte 1
F2. Déformation du film 7
F3. Transfert fluidique au niveau de la vanne 2
F4. Basculement de la languette 8
F5. Force de rétreint du fil en matériau à mémoire de forme 22
F6. Basculement du levier 15 sous l'action du fil en matériau à mémoire de forme 20

## Revendications

1. Vanne (2), traversée par au moins un canal (3), permettant de diriger au moins un fluide (F3) mû par des moyens de transfert au sein d'un dispositif (1), le dispositif (1) comportant au moins une face (4), éventuellement plane, la vanne (2) est constituée d'une part d'un film (7 ou 16), flexible et/ou qui peut être déformé, fixé sur tout ou partie de la face (4) dudit dispositif (1), et d'autre part d'un actionneur du film (7 ou 16), qui permet d'activer ou de désactiver ladite vanne (2), cet actionneur étant constitué par une source électrique, qui agit directement sur un polymère électro-actif ou sur un matériau à mémoire de forme.

2. Vanne, selon la revendication 1, **caractérisée par le fait que** le dispositif (1) est constitué par une carte d'analyse (1) comportant deux faces (4 et 5), éventuellement planes et reliées l'une (4) à l'autre (5) par un bord (6), la vanne (2) est constituée d'une part d'un film (7 ou 16), flexible et/ou qui peut être déformé, fixé sur tout ou partie d'au moins l'une des faces (4 et/ou 5).

3. Vanne, selon l'une quelconque des revendications 1 ou 2, **caractérisée par le fait que** le film (7) est constitué par au moins une couche de polymère électro-actif permettant d'activer ou de désactiver directement la vanne (2).

4. Vanne, selon l'une quelconque des revendications 1 à 3, **caractérisée par le fait que** le film (7) est constitué d'une couche de polymère électro-actif associé à une membrane poreuse revêtue sur l'autre de ses faces d'une couche métallique d'or ou d'argent, le polymère électro-actif constituant soit l'électrode positive soit l'électrode négative et la couche métallique constituant l'électrode de polarité complémentaire de l'actionneur ou source de courant électrique.

5. Vanne, selon l'une quelconque des revendications 1 à 3, **caractérisée par le fait que** le film (7) est constitué par une membrane poreuse revêtue sur chacune de ses faces d'une couche de polymère électro-actif, constituant pour l'une des couches l'électrode positive et pour l'autre couche l'électrode négative de l'actionneur ou source de courant électrique.

6. Vanne, selon l'une quelconque des revendications 3 à 5, **caractérisée par le fait que** une couche de polymère électro-actif est constituée de polyaniline et/ou de polypyrrole et/ou de polythiophène et/ou polyparaphénylvylène et/ou poly-(p-pyridyl vinylène), éventuellement associé à du polyéthylène.

7. Vanne, selon l'une quelconque des revendications 3 à 5, **caractérisée par le fait que** la couche poreuse est constituée de tout matériau ou mélange de matériaux dont la porosité laisse passer les ions, tel que téflon, polyamide, cellulose, polyacétate et/ou polycarbonate.

8. Vanne, selon l'une quelconque des revendications 1 ou 2, **caractérisée par le fait qu'**un mécanisme de commande (13) est présent entre le film (16) et l'actionneur.

9. Vanne, selon la revendication 8, **caractérisée par le fait que** le mécanisme de commande (13) est constitué en toute ou partie par un polymère électro-actif selon les revendications 3 à 8, ou par un matériau à mémoire de forme (14), permettant d'activer ou de désactiver indirectement la vanne (2).

10. Vanne, selon l'une quelconque des revendications 1 ou 9, **caractérisée par le fait que** le polymère électro-actif est constitué par une bande longitudinale d'au moins une couche de polymère électro-actif, ou que le matériau à mémoire de forme (14) est constitué par un fil en alliage complexe dont la structure se modifie en fonction de la température, tel qu'un alliage de nickel.et de titane.

11. Vanne, selon l'une quelconque des revendications 8 à 10, **caractérisée par le fait que** le matériau à mémoire de forme (14) coopère avec un levier basculant (15) et constituent ensemble toute ou partie du mécanisme de commande (13).

12. Vanne, selon la revendication 11, **caractérisée par le fait que** le levier basculant (15) est constitué d'une partie flexible (18) et d'une partie rigide (19), la partie rigide coopérant avec un moyen de compression (8) de la vanne (2), le matériau à mémoire de forme (14), le levier (15) et le moyen de compression (8) constituent ensemble toute ou partie du mécanisme de commande (13).

13. Carte d'analyse contenant au moins une vanne, selon l'une quelconque des revendications 1 à 12.

14. Procédé d'activation d'une vanne, selon l'une quelconque des revendications 1 à 12, **caractérisé en ce qu'**il consiste à :
• appliquer un courant électrique à un film ou un fil en polymère électro-actif ou en un métal à mémoire de forme en position de repos, la vanne étant en position ouverte ou fermée,
• maintenir le courant pour conserver le film ou le fil en position active correspondant à une action directe ou indirecte sur la vanne en position fermée ou ouverte, et
• arrêter le courant pour que ledit film ou fil retourne en position de repos et ladite vanne retourne en position ouverte ou fermée.

## Claims

1. A valve (2), penetrated by at least one channel (3), enabling the directing of at least one fluid (F3) set in motion by transfer means within a device (1), the device (1) comprising at least one face (4) which is possibly planar, the valve (2) being composed, on the one hand, of a film (7 or 16) which is flexible and/or which can be deformed, which is fixed onto all or part of the face (4) of said device (1) and, on the other hand, of an actuator of the film (7 or 16), which enables the activation or deactivation of said valve (2), this actuator being composed of an electrical source which acts directly on an electroactive polymer or on a shape memory material.

2. The valve, according to Claim 1, **characterised in that** the device (1) is composed of an analysis card (1) comprising two faces (4 and 5) which are possibly planar, the face (4) being connected to the face (5) by an edge (6), the valve (2) being composed, on the one hand, of a film (7 or 16) which is flexible and/or which can be deformed and which is fixed onto all or part of at least one of the faces (4 and/or 5).

3. The valve, according to any one of Claims 1 or 2, **characterised in that** the film (7) is composed of at least one layer of electroactive polymer enabling the direct activation or deactivation of the valve (2).

4. The valve, according to any one of Claims 1 to 3, **characterised in that** the film (7) is composed of a layer of electroactive polymer associated with a porous membrane coated, on the other of its faces, with a metallic layer of gold or silver, the electroactive polymer constituting either the positive electrode or the negative electrode and the metallic layer constituting the complementary polarity electrode of the actuator or source of electric current.

5. The valve, according to any one of Claims 1 to 3, **characterised in that** the film (7) is composed of a porous membrane coated, on each of its faces, with a layer of electroactive polymer, constituting, for one of the layers, the positive electrode, and for the other layer, the negative electrode of the actuator or source of electric current.

6. The valve, according to any one of Claims 3 to 5, **characterised in that** a layer of electroactive polymer is composed of polyaniline and/or polypyrrole and/or polythiophene and/or polyparaphenylvylene and/or poly-(p-pyridyl vinylene), possibly associated with polyethylene.

7. The valve, according to any one of Claims 3 to 5, **characterised in that** the porous layer is composed of any material or mixture of materials, the porosity of which allows ions to pass through, such as teflon, polyamide, cellulose, polyacetate and/or polycarbonate.

8. The valve, according to any one of Claims 1 or 2, **characterised in that** a control mechanism (13) is present between the film (16) and the actuator.

9. The valve, according to Claim 8, **characterised in that** the control mechanism (13) is composed wholly or partly of an electroactive polymer according to Claims 3 to 8, or by a shape memory material (14), enabling the indirect activation or deactivation of the valve (2).

10. The valve, according to any one of Claims 1 or 9, **characterised in that** the electroactive polymer is composed of a longitudinal strip of at least one layer of electroactive polymer, or **in that** the shape memory material (14) is composed of a wire made from a complex alloy, the structure of which alters depending on the temperature, such as a nickel and titanium alloy.

11. The valve, according to any one of Claims 8 to 10, **characterised in that** the shape memory material (14) co-operates with a tilting lever (15) with which it constitutes, collectively, all or part of the control mechanism (13).

12. The valve, according to Claim 11, **characterised in that** the tilting lever (15) is composed of a flexible part (18) and a rigid part (19), the rigid part co-operating with a compression means (8) of the valve (2), the shape memory material (14), the lever (15) and the compression means (8) collectively constituting all or part of the control mechanism (13).

13. The analysis card containing at least one valve, according to any one of Claims 1 to 12.

14. A method for activating a valve, according to any one of Claims 1 to 12, **characterised in that** it consists in:
• applying an electrical current to a film or a wire made from an electroactive polymer or from a shape memory metal in the rest position, the valve being in the open, or closed, position,
• maintaining the current in order to retain the film or the wire in the active position corresponding to a direct or indirect action on the valve in the closed, or open, position, and
• stopping the current such that said film or wire returns to the rest position and said valve returns to the open, or closed, position.

## Patentansprüche

1. Ein Ventil (2), das von mindestens einem Kanal (3) durchdrungen ist und das Leiten mindestens eines Fluids (F3), das innerhalb einer Vorrichtung (1) von Übertragungsmitteln bewegt wird, ermöglicht, wobei die Vorrichtung (1) mindestens eine, möglicherweise ebene, Seite (4) beinhaltet, wobei das Ventil (2) einerseits aus einer Folie (7 oder 16), die flexibel ist und/oder die verformt werden kann und auf der gesamten oder einem Teil der Seite (4) der Vorrichtung (1) befestigt ist, und andererseits aus einem Stellglied der Folie (7 oder 16), das das Aktivieren oder Deaktivieren des Ventils (2) ermöglicht, besteht, wobei dieses Stellglied aus einer elektrischen Quelle besteht, die direkt auf ein elektroaktives Polymer oder auf ein Material mit Formgedächtnis wirkt.

2. Ventil gemäß Anspruch 1, **dadurch gekennzeichnet, dass** die Vorrichtung (1) sich aus einer Analysekarte (1) zusammensetzt, die zwei Seiten (4 und 5), die möglicherweise eben sind und eine (4) mit der anderen (5) über einen Rand (6) verbunden ist, beinhaltet, wobei das Ventil (2) einerseits aus einer Folie (7 oder 16) besteht, die flexibel ist und/oder die verformt werden kann und auf der gesamten oder einem Teil von mindestens einer der Flächen (4 und/oder 5) befestigt ist.

3. Ventil gemäß Anspruch 1 oder 2, **dadurch gekennzeichnet, dass** die Folie (7) sich aus mindestens einer elektroaktiven Polymerschicht zusammensetzt, die das direkte Aktivieren oder Deaktivieren des Ventils (2) ermöglicht.

4. Ventil gemäß einem der Ansprüche 1 bis 3, **dadurch gekennzeichnet, dass** die Folie (7) aus einer elektroaktiven Polymerschicht besteht, die mit einer porösen Membran verbunden ist, die an ihrer anderen Seite mit einer metallischen Schicht aus Gold oder Silber beschichtet ist, wobei das elektroaktive Polymer entweder die positive Elektrode oder die negative Elektrode bildet und die metallische Schicht die Elektrode mit komplementärer Polarität des Stellglieds oder der Quelle elektrischen Stroms bildet.

5. Ventil gemäß einem der Ansprüche 1 bis 3, **dadurch gekennzeichnet, dass** die Folie (7) sich aus einer porösen Membran zusammensetzt, die auf jeder ihrer Seiten mit einer elektroaktiven Polymerschicht beschichtet ist, die für eine der Schichten die positive Elektrode bildet und für die andere Schicht die negative Elektrode des Stellglieds oder der Quelle elektrischen Stroms bildet.

6. Ventil gemäß einem der Ansprüche 3 bis 5, **dadurch gekennzeichnet, dass** eine elektroaktive Polymerschicht aus Polyanilin und/oder Polypyrrol und/oder Polythiophen und/oder Polyparaphenylvylen und/oder Poly-(p-pyridyl-vinylen), möglicherweise verbunden mit Polyethylen, besteht.

7. Ventil gemäß einem der Ansprüche 3 bis 5, **dadurch gekennzeichnet, dass** die poröse Schicht aus jedem Material oder jeder Mischung aus Materialien besteht, dessen/deren Porosität Ionen, wie etwa Teflon, Polyamid, Zellulose, Polyacetat und/oder Polykarbonat, durchlässt.

8. Ventil gemäß Anspruch 1 oder 2, **dadurch gekennzeichnet, dass** zwischen der Folie (16) und dem Stellglied ein Steuermechanismus (13) vorliegt.

9. Ventil gemäß Anspruch 8, **dadurch gekennzeichnet dass** der Steuermechanismus (13) völlig oder teilweise aus einem elektroaktiven Polymer gemäß den Ansprüchen 3 bis 8 oder aus einem Material mit Formgedächtnis (14) zusammengesetzt ist, wodurch das mittelbare Aktivieren oder Deaktivieren des Ventils (2) ermöglicht wird.

10. Ventil gemäß einem der Ansprüche 1 bis 9, **dadurch gekennzeichnet, dass** das elektroaktive Polymer aus einem längslaufenden Streifen mindestens einer elektroaktiven Polymerschicht zusammengesetzt ist, oder dass das Material mit Formgedächtnis (14) aus einem Draht aus einer komplexen Legierung zusammengesetzt ist, dessen Struktur sich in Abhängigkeit von der Temperatur verändert, wie etwa eine Nickel- und Titanlegierung.

11. Ventil gemäß einem der Ansprüche 8 bis 10, **dadurch gekennzeichnet, dass** das Material mit Formgedächtnis (14) mit einem Kipphebel (15) zusammenarbeitet und beide miteinander den gesamten oder einen Teil von dem Steuermechanismus (13) bildet.

12. Ventil gemäß Anspruch 11, **dadurch gekennzeichnet, dass** der Kipphebel (15) aus einem flexiblen Tell (18) und einem steifen Teil (19) besteht, wobei der steife Teil mit einem Verdichtungsmittel (8) des Ventils (2) zusammenwirkt, wobei das Material mit Formgedächtnis (14), der Hebel (15) und das Verdichtungsmittel (8) miteinander den gesamten oder einen Teil von dem Steuermechanismus (13) bilden.

13. Eine mindestens ein Ventil enthaltende Analysekarte gemäß einem der Ansprüche 1 bis 12.

14. Ein Verfahren zum Aktivieren eines Ventils gemäß einem der Ansprüche 1 bis 12, **dadurch gekennzeichnet, dass** es Folgendes beinhaltet:
• Anlegen von elektrischem Strom an eine Folie oder einen Draht aus elektroaktivem Polymer oder einem Metall mit Formgedächtnis in der Ruheposition, wobei das Ventil in einer offenen oder geschlossenen Position ist,
• Aufrechterhalten des Stroms zum Festhalten der Folie oder des Drahts in der aktiven Position, die einer unmittelbaren oder mittelbaren Einwirkung auf das Ventil in geschlossener oder offener Position entspricht und
• Abschalten des Stroms, damit die Folie oder der Draht in die Ruheposition zurückkehrt und das Ventil in die offene oder geschlossene Position zurückkehrt.
